# EUROPEAN PATENT APPLICATION

(11) **EP 2 672 504 A2**
(43) Date of publication of application: **11.12.2013**
(21) Application number: 13460034.5
(22) Date of filing: 27.05.2013
(51) Int. Cl.: H01J 37/244

(54) **Combined directional electron detector**

(30) Priority: 06.06.2012 PL 39943812
(71) Applicant: POLITECHNIKA WROCLAWSKA, 50-370 Wroclaw (PL)
(72) Inventor: Slówko, Witold, 51-657 Wroclaw (PL)

(57) **Abstract**

The combined directional electron detector, intended particularly for environmental scanning electron microscopes with variable gas pressure in the sample chamber, also dedicated to the multidetector three-dimensional imaging of surface topographies, has an intermediate chamber (16) situated on the path of the electron beam (EB) to the sample stage (2), filled with gas with an intermediate pressure (P₂) lower than the working gas pressure (P₁) in the sample chamber where the place of emission of the electrons subject to detection is located, is equipped with a lower aperture (1) throttling the flow of the gas to the intermediate chamber (16) and in the space between the intermediate chamber (16) and the sample stage (2) it has four anodes (3) in the form of four electrodes identical in shape, arranged in pairs symmetrically around the electron beam (EB) axis, equipped with separate electrical leads and positively biased relative to the wall of the intermediate chamber (16). In the space between the anodes (3) and the sample stage (2) there is an external screening cathode (6) with a hole, delimiting from the sample stage (2) side the maximal backscattered electron (BSE₂) detection angle (β₂) at which the electrons enter the electric discharge area around the anodes (3). Inside the intermediate chamber (16) there is a quadrant semiconductor BSE₁ detector (13) with four identical sectors active for electrons, arranged symmetrically relative to the electron beam (EB) axis, with their active surfaces facing the lower throttling aperture (1).

## Description

The subject of the invention is a combined directional electron detector intended particularly for environmental scanning electron microscopes with variable gas pressure in the sample chamber, and also dedicated to the three-dimensional imaging of surface topographies by the multi-detector method.

In the patent application no. P396065, Slówko Witold "Directional electron detection unit", a directional electron detection unit intended particularly for scanning electron microscopes with variable gas pressure in the sample chamber is described. The unit comprises an intermediate chamber, situated on the path of the electron beam to the sample stage, filled with gas whose pressure is lower than the gas pressure in the sample chamber where the place of emission of the electrons subject to detection is located, and at least one aperture, situated on the electron beam axis, throttling the flow of gas to the intermediate chamber. Inside the intermediate chamber there is an electron detector system consisting of at least two semiconductor electron detectors, advantageously in the form of PIN diodes, arranged in pairs symmetrically to the electron beam, with their active surfaces facing the lower throttling aperture and the sample stage, at a distance from the aperture at least three times larger than the lower throttling aperture opening diameter. Advantageously, the electron detector system is an integrated multisector system with four active sectors produced on a common semiconductor base.

The above mentioned system detects the stream of electrons entering the intermediate chamber through the lower throttling aperture opening usually less than 1 mm in diameter. Consequently, only electrons with initial velocities zenithally directed along the microscope optical axis, with slight angular deflections from this direction, delimited by the diameter of the lower throttling aperture diameter and its distance from the sample stage, are subject to detection. For this reason, this distance must be very small, of similar size as the aperture diameter, so that the diameter of the electron beam on the detector is larger than the latter's outer diameter. The small distance of the aperture from the examined object reduces electron beam scatter in the gas with elevated pressure and ensures the proper operation of the detection system under pressures up to 10 hPa, but at the same time it is a source of nonuniformity and instability of this pressure near the sample's surface, making it difficult to keep the evaporating sample in thermodynamic equilibrium. In the extreme case, the liquid preparation may be sucked into the detector. Because of the semiconductor detector's characteristics, electrons with a potential energy higher than 1 keV, classified as backscattered electrons (BSE), are subject to detection and the output signal increases with the energy of the electrons, exhibiting a strong material contrast and a weak topographic contrast. The latter characteristic, stemming mainly from the zenithal direction of the BSEs subject to detection, makes it difficult to quantitatively reconstruct poorly modulated surface topographies. Furthermore, biological objects are characterized by low density whereby the initial energies of the BSEs are also relatively low and so the semiconductor detector system's output signal is weaker. Thus there is a need to eliminate the above electron detection system's inconveniences, particularly acute in the case of the multidetector three-dimensional imaging of smooth or semiliquid objects, such as biological specimens.

According to the invention, the above shortcomings and inconveniences are eliminated by the combined directional electron detector, intended particularly for environmental scanning electron microscopes with variable gas pressure in the sample chamber as well as dedicated to the three-dimensional imaging of surface topographies by the multidetector method, comprising an intermediate chamber situated on the path of the electron beam to the sample stage, filled with gas whose pressure is lower that the gas pressure in the sample chamber where the emission of the electrons subject to detection takes place, and equipped with at least one aperture, situated on the electron beam axis, throttling the flow of gas to the intermediate chamber.

According to the invention, the idea of the detector consists in incorporating, in the space between the intermediate chamber and the sample stage, at least four anodes, in the form of conducting electrodes, arranged symmetrically to the electron beam, having separate electrical leads positively biased relative to at least one of the intermediate chamber walls.

Advantageously the detector's anodes have the form of geometric figures appropriately shaped from wire mesh, whose outer contour encompasses a much larger surface area than the physical surface of the anodes.

Advantageously, the detector has, in the space between the anodes and the sample stage, an external screening cathode with a hole, advantageously circular in shape, symmetrical to the electron beam axis, delimiting from the sample stage side the maximal angle of detection of backscattered electrons BSE₂ at which they enter the electric discharge area around the anodes.

Advantageously, the detector has an external screening cathode movably attached so that it can be moved along the electron beam axis in order to change the maximal BSE₂ detection angle.

Advantageously, the detector's intermediate chamber casing is vacuum closed by the cathode ring and by the focusing cathode tightly secured in the cathode ring's central hole by means of an insulating insert.

Advantageously, the detector has a lower throttling aperture vacuum-tightly secured in the focusing electrode's hole and situated on the electron beam's common axis.

Advantageously, the detector's lower throttling aperture is electrically insulated from the focusing cathode and equipped with an electrical lead.

Advantageously, in the neighbourhood of the anodes the detector has at least one cathode coated with an emission layer made of a material with a secondary emission factor higher than unity, advantageously an alundum Al₂O₃:Al layer.

\ Advantageously, between the anodes the detector has separating walls with conducting surfaces, arranged symmetrically around the electron beam axis.

Advantageously, inside the intermediate chamber the detector has a quadrant semiconductor BSE₁ detector with four sectors active for electrons, arranged in pairs symmetrically to the electron beam axis, with their active surfaces facing the lower throttling aperture.

Advantageously, between the quadrant semiconductor BSE₁ detector and the lower throttling aperture, on the electron beam axis the detector has an internal BSE₁ aperture defining the limited BSE₁ detection angle.

Advantageously, between the quadrant semiconductor BSE₁ detector and the lower throttling aperture the detector has four vertical partitions symmetrically arranged around the electron beam axis, with the projections of the vertical partitions, parallel to the electron beam axis, onto the quadrant semiconductor BSE₁ detector, situated along the gaps between this detector's sectors active for electrons.

Advantageously, the parallel projections of the straight lines connecting the geometric centres of the opposite anodes onto the quadrant semiconductor BSE₁ detector are situated approximately on the straight lines connecting the geometric centres of this detector's sectors active for electrons.

Advantageously, the detector has the intermediate chamber connected to a vacuum system equipped with an auxiliary valve dosing gas to the intermediate chamber during the operation of the detector.

Advantageously, the detector has the intermediate chamber casing attached movably relative to the objective lens and connected to a mechanism making its movement possible.

Advantageously, the detector has the intermediate chamber casing connected to the objective lens via mechanical elements making possible their mutual movement during the operation of the detector.

Advantageously, the detector has the quadrant semiconductor BSE₁ detector immovably attached to the objective lens by means of a connector, and has the intermediate chamber casing attached movably relative to the objective lens and connected to a mechanism making its movement possible.

According to the invention, the advantage of the combined directional electron detector is that it can work in a very wide range of working pressures in the sample chamber, from a pressure below 0.1 Pa to a pressure exceeding 1000 Pa. Another major advantage of the detector is that it is the source of all the signals needed to reconstruct the shape and morphology of the examined sample's surface by the multidetector method, using computer signal acquisition and processing. The signals are: the secondary electrons (SE) signal, the electrons backscattered in zenithal direction (BSE₁) signal and the electrons backscattered in horizontal direction (BSE₂) signal. According to the invention, using the combined directional electron detector one can obtain three-dimensional images of dielectric surfaces and water containing objects in their natural state, such as tissues, bacteria, and so on. All the data needed for this purpose can be acquired in a single scanning cycle whereby it is possible to study dynamic processes by fast recording the sequential stages in the process and producing frame-by-frame films. According to the invention, the combined directional electron detector is advantageously connected to an autonomous intermediate vacuum system and used, as an accessory, in standard high-vacuum scanning electron microscopes. In this case, it enables the extension of such microscopes' examining range to elevated pressures, making it possible to obtain three-dimensional imaging of the surface of dielectrics and biological samples in natural state.

The subject of the invention is reproduced in exemplary versions in a drawing in which Figure 1 shows the combined directional electron detector with the immovable attachment of the intermediate chamber and the pumping of the latter through the objective lens. Figure 2 in view A shows a schematic front view of the quadrant semiconductor BSE₁ detector with electrical leads, and in view B, a front view of the cathode ring with attached components and the screening cathode removed. Figure 3 shows the combined directional electron detector with the movable fixing of the intermediate chamber and the pumping of the latter through a side gas pass. Figure 4 shows the combined directional electron detector with the immovable fixing of the quadrant semiconductor BSE₁ detector and with the movable intermediate chamber casing.

### Example 1

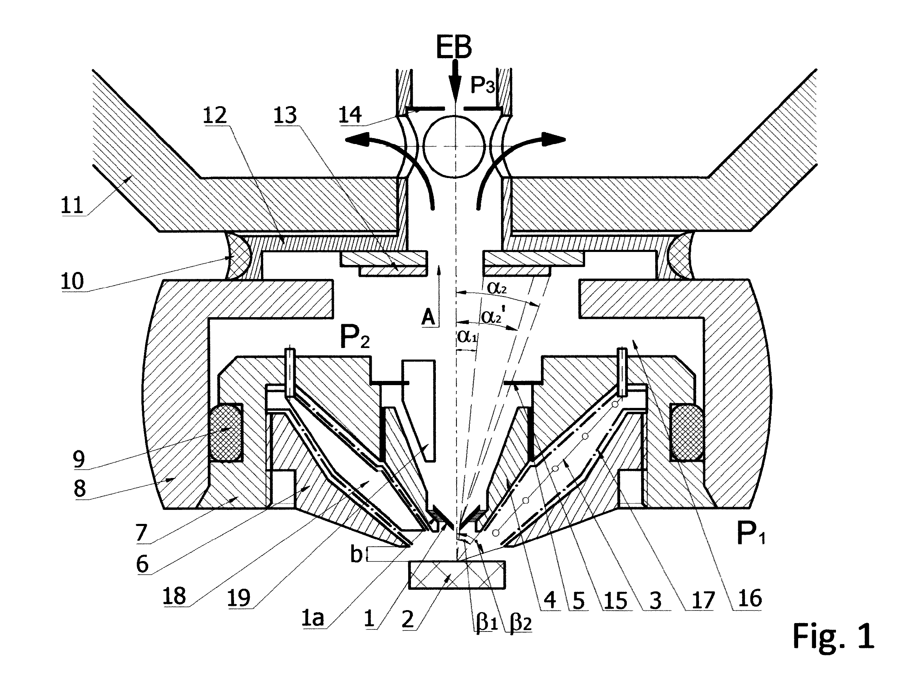

The combined directional electron detector shown in fig. 1 has metal intermediate chamber casing 8 connected to connector 12 in the form of a sleeve secured in a hole in the lower pole piece of the objective lens and equipped with a flange on whose perimeter there is C-seal 10 sealing intermediate chamber casing 8 against the face of objective lens 11. In its cross section C-seal 10 has a shape similar to the letter C, which increases its elasticity and ensures good sealing under light pressure. The sleeve of connector 12 has side pumping holes through which the gas passing to intermediate chamber 16 flows into objective lens 11 whose interior is connected to a differential pumping system whereby intermediate gas pressure P₂ is maintained inside intermediate chamber 16. The sleeve of connector 12 is closed with upper throttling aperture 14 with its opening situated on the electron beam (EB) axis, limiting the flow of gas into the electronoptical column where low gas pressure P₃ prevails.

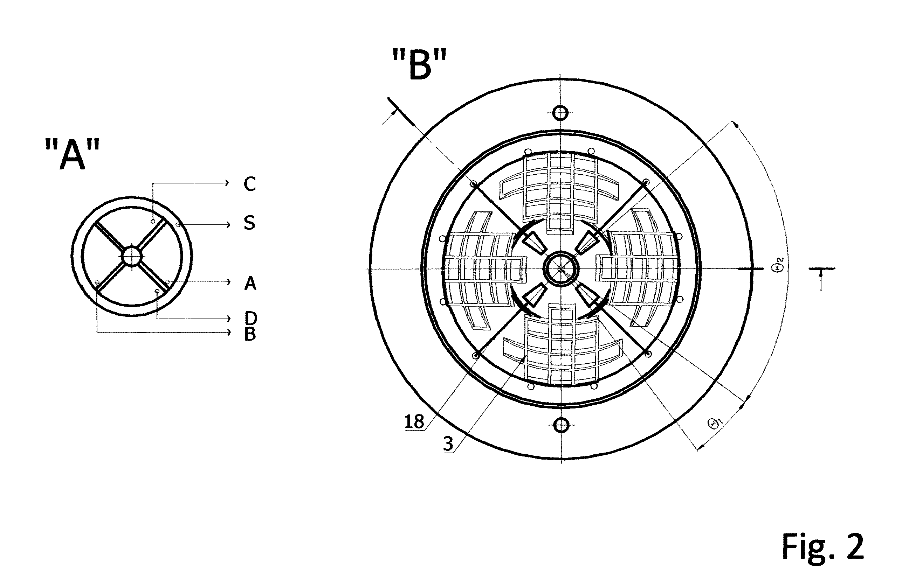

The flange of connector 12 on its side joining intermediate chamber casing 8 has a cavity housing quadrant semiconductor BSE₁ detector 13, in integrated form, with four identical active sectors on a common semiconductor base, arranged symmetrically at every 90° around the EB axis as shown in Fig. 2 view A. Semiconductor BSE₁ detector 13 has a hole on the axis of the electron beam allowing the latter to pass towards sample stage 2, and the front surface of quadrant semiconductor BSE₁ detector 13 faces lower throttling aperture 1. The pervious-to-electrons signal electrodes deposited on the faces of the four sectors, and the substrate of semiconductor BSE₁ detector 13 are equipped with independent electrical leads A, B, C, D and T. On the sample stage 2 side, intermediate chamber casing 8 is vacuum-closed by cathode ring 7 with O-seal 9 secured on its perimeter, and by focusing cathode 4 tightly secured in the central hole of cathode ring 7 by means of insulating insert 5. Focusing cathode 4 has the shape of a truncated cone hollow inside, at the top of which there is lower throttling aperture 1 tightly secured by means of insulating ring 1a. Internal BSE₁ aperture 15 is secured in the upper part of the central hole of cathode ring 7. On the perimeter of internal BSE₁ aperture 15 perpendicularly to its edge there are fixed four vertical partitions 19 arranged symmetrically around the EB axis so that their projections parallel to the EB axis fall on quadrant semiconductor BSE₁ detector 13, along the gaps between the sectors active for electrons. The symmetry axes of cathode ring 7, internal BSE₁ aperture, focusing cathode 4 and lower aperture 1 coincide with the EB axis.

Near the conical outer surfaces of focusing cathode 4 and cathode ring 7, coated with thin emission layer 17 with a high secondary emission factor, there are, symmetrically arranged at every 90° around the EB axis, four anodes 3 in the form of four mesh electrodes identical in shape and size and equipped with separate electrical leads, as shown in Fig. 2 view B. Thus the configuration of anodes 3 is a configuration with quadruple rotational symmetry. Anodes 3 are screened from the sample stage 2 side by external screening cathode 6 in the form of a conical ring screw-connected at its base to cathode ring 7. The diameter of the hole at the top of external screening cathode is slightly larger than that of the top of focusing cathode 4 whereby there is a gap between the cathodes allowing BSE₂ to pass towards anodes 3 positively biased relative to the electrodes constituting the cathodes for the electrical discharge area in the gas, set up in the gap between them. Between anodes 3 there are four identical separating walls 18 with their conducting side surfaces facing anodes 3, arranged symmetrically at every 90° around the EB axis. The shape of their longitudinal section in the symmetry plane lying on axis z fills the gap between cathode ring 7, focusing cathode 4 and external screening cathode 6, leaving a sufficient space ensuring that no short circuits occur between them. The front part of separating walls 18 partially screens the inlet into the detection aperture, as it is expanded to form a trapezium with apex angle Θ₁, as shown in Fig. 2 view B.

The combined directional electron detector built as above operates in the following way. The arrangement of detector components and voltages supplying the detector components is such that the combined directional electron detector can perform the four different functions described below.

First of all, the detector is integrated with intermediate chamber 16 inside which intermediate pressure P₂, lower than elevated working gas pressure P₁ prevailing in the sample chamber, but higher than low gas pressure P₃ in the electronoptical chamber, is maintained. This state is maintained owing to the fact that the flow of gas to lower pressure regions is limited by lower throttling aperture 1 and upper throttling aperture 14 and that intermediate chamber is pumped off through the side holes in the sleeve of connector 12 into objective lens 11, connected to a vacuum system.

The combined directional electron detector's primary function is to detect two groups of BSE electrons, distinguished by the direction of their initial velocity. The first group of electrons subject to detection are electrons backscattered in the zenithal direction, denoted as BSE₁. Their initial velocities are directed at small angles α relative to the EB axis; the angles are smaller than the maximal angle α₂ determined by distance b of sample stage 2 from lower throttling aperture 1 and by the diameter of this aperture opening. Quadrant semiconductor BSE₁ detector 13, advantageously in integrated form, is used for the final detection of this group of electrons. Distance b should be small enough to obtain a shadow image of lower throttling aperture 1 of 0.6 mm in diameter, projected by the electron stream on semiconductor BSE₁ detector 13, whose diameter will be larger than this detector's active diameter of 10 mm. Otherwise, as a result of the movements of the BSE emission spot on the sample, connected with the electron beam scanning, the electron stream hitting the detector will be clipped by the edge of throttling aperture 1, producing the so-called shadowing effect. This means that at a distance of 14 mm of this detector from lower throttling aperture 1, distance b should be smaller than 1.1 mm. In order to increase the scanning area within which no shadowing of the detector by lower throttling aperture 1 occurs, internal BSE₁ aperture 15, delimiting the diameter of the active surface of semiconductor detector BSE₁ 13 and determining the limited BSE₁ detection angle α₂', has been employed. The difference between this angle and the maximal angle α₂ determines scanning field diameter s allowable with respect to shadowing, in accordance with proportion s = 2b(α₂ - α₂'). A reduction in the active surface of semiconductor BSE₁ detector 13 results in a reduction in the embraced electron beam and in a decrease in the detector's sensitivity, especially that the hole in the centre of the detector, being an inactive area, limits the minimal BSE₁ detection angle α₁. Therefore such distance b and the diameters of the semiconductor detector and of the apertures should adopted that the resultant detection angle satisfies the inequality α₁ < α₂'< α₂. In order to make the satisfaction of this inequality possible in different conditions, internal BSE₁ aperture 15 has been secured in a way which permits its replacement. Four vertical partitions 19 have been mounted on the perimeter of the opening of internal BSE₁ aperture 15. The partitions prevent the electrons elastically scattered on the molecules of the gas filling intermediate chamber 16 from passing to the adjacent quadrants of semiconductor BSE₁ detector 13, which otherwise would falsify the information about the directions of their emission.

In the case of three dimensional surface topography reconstruction by the multidetector method, not only shadowing by throttling aperture 1, but also shadowing by surface objects for which the tangent to the surface is inclined relative to the EB axis at an angle smaller than the limited BSE₁ detection angle α₂' occurs. This means that by using small detection angles one can avoid the shadowing effect. For this reason the use of the BSE₁ detector with quadrant semiconductor BSE₁ detector 13 is particularly advantageous for the three-dimensional imaging of surfaces with a strongly modulated topography.

The signal of the electrons backscattered in the zenithal direction, i.e. the BSE₁ signal, is characterized by a low topographic contrast but delivers a high material contrast, enabling the examination of areas little differing in the atomic number of sample components.

In the opposite situation, i.e. when the subject of three-dimensional imaging are objects with a smooth surface and a weakly modulated topography, such as many biological objects, it is advantageous to use electrons backscattered at large anglers β relative to the EB axis, i.e. almost horizontally. The signal of horizontally backscattered electrons is characterized by a high topographic contrast and a lower material contrast. This group of electrons backscattered at large angles β, denoted here as BSE₂, cannot be detected by the above semiconductor BSE₁ detector placed inside intermediate chamber 16 since the electrons will be eliminated by throttling aperture 1. A detector of the ionization type, in the form of a system of electrodes located outside the walls of intermediate chamber 16, i.e. within the area of the microscope sample chamber where elevated working gas pressure P₁ prevails, is used for the directional detection of BSE₂. Between focusing cathode 4 and cathode ring 7 on one side and external screening cathode 6 on the other side there is a ring-shaped gap in which there are four symmetrically arranged anodes 3 equipped with separate electrical leads and positively biased relative to the cathodes. In these conditions, it is possible to produce nonself-sustained gas discharge, classified as the Townsend discharge, whereby the BSE₂ signal subject to detection can be amplified owing to the avalanche ionization of gas molecules. Backscattered electrons BSE₂ can penetrate into this gap and be detected within the angles delimited by distance b of sample stage 2 and by the diameters of the cathode edges defining the entry to the detection gap, i.e. in a range from minimal BSE₂ detection angle β₁, defined by the edge of focusing cathode 4, to maximal BSE₂ detection angle β₂ defined by the edge of external screening cathode 6. Maximal detection angle β₂ can be further adjusted by screwing screening cathode 6 in or out of the screwed seat in cathode ring 7, or by completely removing it if samples are to be examined at a considerable tilt of sample stage 2. Azimuthal BSE₂ detection angle Θ₂ shown in Fig. 2 is smaller than 90°, i.e. smaller than the angle resulting from the division of the round angle into four sectors since a part of the detector's inlet window is screened by the expanded front part of separating walls 18, defining azimuthal BSE₂ detector shadowing angle Θ₁. When azimuthal BSE₂ detector shadowing angle Θ₁ is increased and azimuthal BSE₂ detection angle Θ₂ is decreased, the horizontal direction of electron emission is sampled more precisely, but as the detector's inlet window is reduced in size, the signal decreases. Therefore a balance between the two angles should be found. According to the principles of the multidetector method of the three-dimensional reconstruction of surface topography, the centres of the inlet windows of the appropriate detectors should lie on the principal axes of sample surface scanning. Therefore, in order to satisfy this condition for both BSE₁ and BSE₂ detection, the inlet windows of the ionization detector should be so positioned as the active fields of the semiconductor detector, which means the projections of separating walls 18 should fall onto quadrant semiconductor BSE₁ detector 13 along the gaps between the sectors active for electrons. It is particularly important to maintain full symmetry of the opposite sectors of both BSE₁ and BSE₂ detectors relative to the EB axis. This means that anodes 3 should be symmetrical in pairs and the straight lines connecting the geometric centres of opposite anodes 3 should be orthogonal and intersect each other on the EB axis. The same is recommended for quadrant semiconductor BSE₁ detector 13. Noncompliance with these recommendations is a source of errors in the three-dimensional reconstruction of surface topography by the multidetector method.

Due to the relatively high initial energy, implying a small active cross section for collisions with gas molecules, and also due to small distance b of sample stage 2 from the inlet into the detection gap, most of the BSE₂ electrons reach it consistently with the directions of the initial velocities, despite elevated working gas pressure P₁ in the sample chamber. However, at elevated pressure P₁ numerous collisions with gas molecules occur along the long path inside the detection gap. Most of them are elastic collisions, changing the direction of electron velocity towards one of the cathodes coated with emission layer 17. Owing to the high secondary emission factor of this layer a BSE₂ electron hitting its surface causes the emission of more than one secondary electron (SE) with a small initial energy at which the cross section active for ionizing collisions with gas molecules is large. Under the influence of the electric field generated by each of anodes 3 the secondary electrons move transversely to the gap and in ionizing collisions undergo avalanche multiplication, finally reaching anode 3. Anode 3 is made of highly transparent metal mesh, advantageously of wire shaped into a loop forming a geometric figure whose physical surface is much smaller than the surface area demarcated by the outer contour of this electrode. Owing to this design of anode 3, even if working gas pressure P₁ is low and the mean free path of the electrons is comparable with the cathode-anode distance, the secondary electrons accelerated and slowed down in the electric field of anode 3 move oscillatingly from one cathode to the opposite cathode, many times passing through the meshes of anode 3 until their potential energy is spent, mainly on the multiplication of electrons in ionizing collisions. Owing to this, the BSE₂ signal current reaching anode 3 is also amplified many times. In this example, emission layer 17 in the form of a thin Al₂O₃:Al layer, i.e. an alundum layer doped with aluminium in order to increase its electrical conductance, was used. Although the secondary emission factor of such a layer amounts to 6 at a primary energy of 1 keV, i.e. it is lower than that of magnesium oxide (MgO) also used for this purpose, the layer is characterized by high chemical and mechanical resistance contributing to high detector durability. Under very low working pressure P₁, BSE₂ electrons do not undergo a sufficient number of collisions ionizing gas molecules to obtain significant amplification of the signal, but upon hitting emission layer 17 undergo multiplication, which helps to obtain a BSE₂ signal suitable for three dimensional imaging, in a wide range of working pressure P₁, including low working pressures.

The four output signals from the diodes incorporated in quadrant semiconductor BSE₁ detector 13, similarly as the four output signals from anodes 3 of ionization BSE₂ detector, obtained via the electrical leads are amplified by multichannel electronic amplifiers and digitally processed in a computer in order to reconstruct the shape of the examined surface. It is advantageous to apply the texture obtained from the signal of the secondary electrons (SE) emitted from the sample during scanning with the electron beam, to the reconstructed surface shape. Therefore the fourth function of the combined directional electron detector is to detect the signal of secondary electrons (SE). Lower throttling aperture 1 positively biased relative to sample stage 2 with extraction voltage amounting to a few hundred volts has been used here as the SE detector. Under the influence of extraction voltage the secondary electrons move towards lower throttling aperture 1 at a small distance from the electron beam and undergo multiplication in the avalanche of ionizing collisions. If working gas pressure P₁ in the working chamber is relatively low, then along short distance b of sample stage 2 to lower throttling aperture there occurs a small number of ionizing collisions and so the amplification of the signal in this way is also small. However, lower throttling aperture 1, in the form of a cone with a hole at its apex, is secured, by means of insulating ring 1a, in the outlet part of the cylindrical channel in focusing cathode 4 so that the top of throttling aperture 1 is situated at the level of this channel's edge. Since focusing cathode 4 is biased with a very low voltage of ±20 V while lower throttling aperture is supplied with a much higher extraction voltage, a strong electric field is generated around lower throttling aperture 1. The electric field constitutes an electron lens focusing the stream of secondary electrons in the opening of throttling aperture 1. Having gained high kinetic energy in this field, the electrons penetrate deep into intermediate chamber 16, subsequently are again attracted by lower throttling aperture 1 and pass through its opening towards the stage, repeating this cycle many times. In this way the path of the secondary electrons in the rarefied gas is considerably extended and the probability of ionizing collisions increases, which ultimately results in a greater current amplification of the signal of the secondary electrons in the circuit of throttling aperture 1 which ultimately serves as their collector.

In many cases, it is advantageous if focusing cathode 4 is biased with a small negative voltage relative to sample stage 2. Then it catches some of the positive ions produced in the ionization avalanche whereby a too large positive space charge near the examined object is avoided.

### Example 2

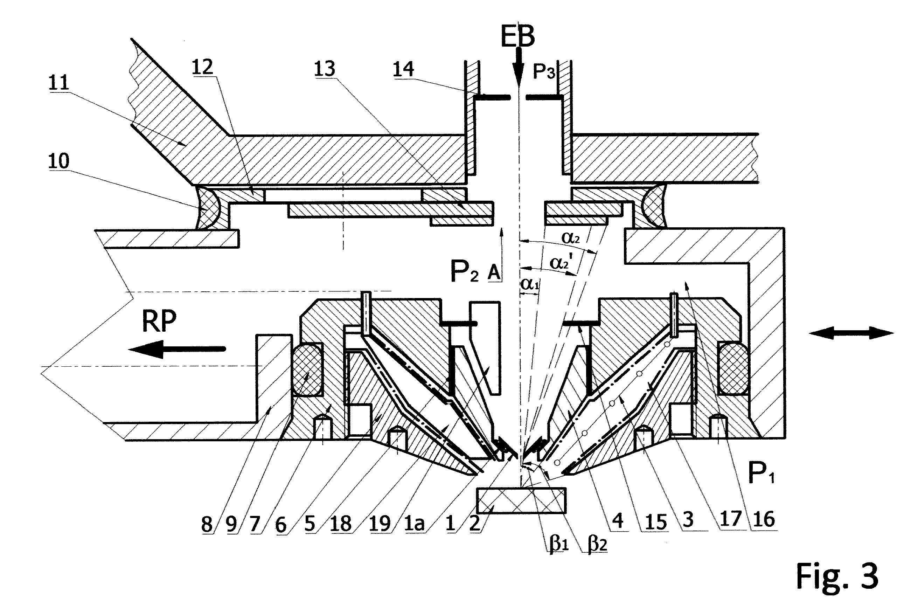

The combined directional electron detector shown in Fig. 3 is built as in the first example, with the difference that it has intermediate chamber casing 8 with a side gas pass leading to vacuum system RP, with connector 12 mounted on the top surface of intermediate chamber casing 8 having the form of a disk with a hole on the EB axis and a cavity housing quadrant semiconductor BSE₁ detector 13, while upper throttling aperture 14 is mounted in a sleeve which is not connected to connector 12. Similarly as in the first example, connector 12 has a ring-shaped C-seal 10 sealing intermediate chamber casing 8 against the face of objective lens 11. Intermediate chamber casing 8 is connected to a mechanism making possible its movement relative to objective lens 11 without interrupting the operation of the combined directional electron detector. Vacuum system RP is equipped with an auxiliary dosing valve for feeding gas into intermediate chamber 16.

The combined directional electron detector in this version operates in a similar way as described in the first example, with the difference that in order to maintain intermediate gas pressure P₂ inside intermediate chamber 16 the gas is pumped through the side channel in intermediate chamber casing 8, leading to vacuum system RP. The auxiliary dosing valve in vacuum system RP makes it possible to feed an additional gas stream into intermediate chamber 16 and increase intermediate gas pressure P₂ prevailing in it to above working gas pressure P₁ in the sample chamber. The dosing of gas into intermediate chamber 16 is used when working gas pressure P₁ is too low in order to obtain a sufficient amplification of the SE signal in the sample chamber. Secondary electrons are accelerated and focused in the extraction field formed by throttling aperture 1 and focusing cathode 4 and most of them penetrate through the opening in this aperture into intermediate chamber 16 where they undergo multiplication in ionizing collisions with the molecules of the gas whose intermediate pressure P₂ is adjusted by means of the auxiliary dosing valve.

The connection of intermediate chamber casing 8 with the mechanism possible its movement relative to objective lens 11 without interrupting the operation of the combined directional electron detector enables the precise alignment of the detector on the EB axis on the basis of the observed microscopic image. It also makes it possible to temporary remove the detector outside the nearest vicinity of objective lens 11 in order to effect other microscope working modes which do not require the use of the combined directional electron detector.

### Example 3

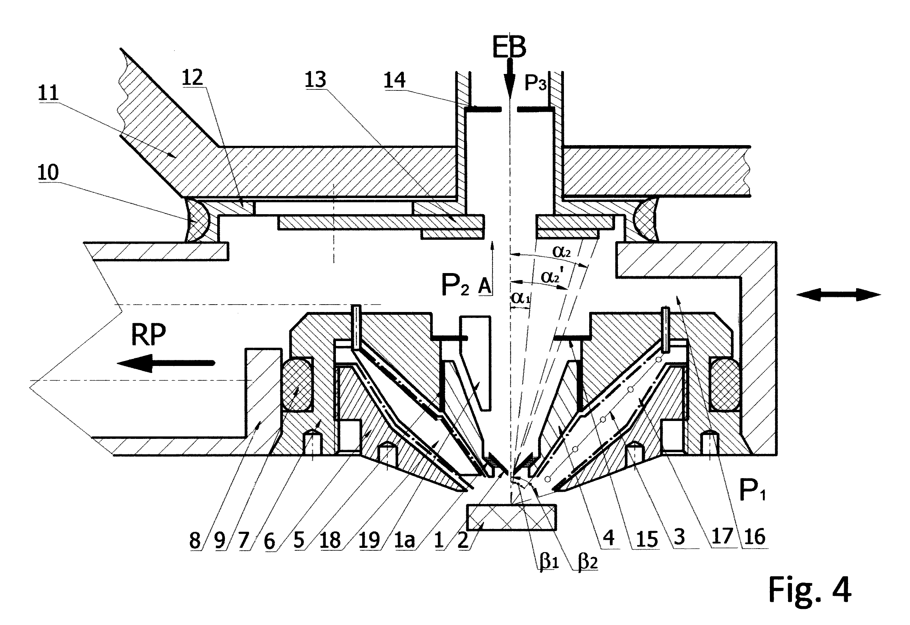

The combined directional electron detector as shown in Fig. 4 is built as in the second example, with the difference that connector 12 is not attached to intermediate chamber casing 8, but to objective lens 11, since, similarly as in the first example, it has the form of a sleeve secured in the hole of the lower pole shoe of objective lens 11 and equipped with a flange with a cavity housing quadrant semiconductor BSE₁ 13 and ring-shaped C-seal 10 placed on the perimeter.

The combined directional electron detector in this version operates in a similar way as described in the second example, with the difference that while the detector is moved by means of the mechanism connected to intermediate chamber casing 8, connector 12 remains motionless in a fixed position relative to objective lens 11, together with quadrant semiconductor BSE₁ detector attached to it. Consequently, it is possible to temporary remove intermediate chamber casing 8 with the BSE₂ detector outside the nearest vicinity of objective lens 11 and to completely expose quadrant semiconductor BSE₁ detector 13 whereby in high vacuum conditions the directional detection of BSE and the three-dimensional imaging of the investigated object's surface can be performed without the limitations introduced by lower throttling aperture 1.

### List of figure symbols:

- 1: - lower throttling aperture,

- 1a: - insulating ring,
- 2: - sample stage,
- 3: - anode,
- 4: - focusing cathode,
- 5: - insulating insert,
- 6: - external screening cathode,
- 7: - cathode ring,
- 8: - intermediate chamber casing,
- 9: - O-seal,
- 10: - C-seal,
- 11: - objective lens,
- 12: - connector,
- 13: - quadrant semiconductor BSE₁ detector,
- 14: - upper throttling aperture,
- 15: - internal BSE₁ aperture,
- 16: - intermediate chamber,
- 17: - emission layer,
- 18: - separating wall,
- 19: - vertical partition,
- α₁: - minimal vertical BSE₁ detection angle,
- α₂: - maximal vertical BSE₁ detection angle,
- α₂': - limited vertical BSE₁ detection angle,

- β₁: - minimal vertical BSE₂ detection angle,
- β₂: - maximal vertical BSE₂ detection angle,
- Θ₁: - azimuthal BSE₂ detector shadowing angle,
- Θ₂: - azimuthal BSE₂ detector inlet angle,
- P₁: - working gas pressure (inside sample chamber),
- P₂: - intermediate gas pressure (inside intermediate chamber),
- P₃: - low gas pressure (inside electronoptical column),
- EB: - electron beam,
- RP: - vacuum system.

### List of symbols used in text:

- SE: - secondary electrons,
- BSE₁: - electrons backscattered in zenithal direction (at small angle to electron beam axis),
- BSE₂: - electrons backscattered in horizontal direction (at large angle to electron beam axis).

## Claims

1. The combined directional electron detector, intended particularly for environmental scanning electron microscopes with variable gas pressure in the sample chamber, also dedicated to the multidetector three-dimensional imaging of surface topographies. comprising an intermediate chamber situated on the path of the electron beam to the sample stage, filled with gas whose pressure is lower than the working gas pressure in the sample chamber where the place of emission of the electrons subject to detection is located, equipped with at least one aperture throttling the flow of the gas to the intermediate chamber, situated on the electron beam path, unique in this that in the space between the intermediate chamber (16) and the sample stage (2) it has at least four anodes (3) arranged symmetrically relative to the axis of the electron beam (EB), having the form of conducting electrodes, equipped with separate electrical leads and positively biased relative to at least one element encasing the intermediate chamber (16).

2. The detector, according to claim 1, is unique in this that it has anodes (3) in the form of geometric figures made of metal mesh, advantageously formed from wire, with the outer contour of the anodes (3) encompassing a surface area much larger than the physical surface of the anodes (3).

3. The detector, according to claim 1, is unique in this that in the space between the anodes (3) and the sample stage (2) it has an external screening cathode (6) with a hole whose shape, advantageously circular, is symmetrical relative to the electron beam (EB), advantageously delimiting from the sample stage (3) side the maximal backscattered electrons BSE₂ detection angle (β₂) at which the electrons enter the electric discharge area around the anodes (3).

4. The detector, according to claim 1 and claim 3, unique in this that it has the external screening cathode (6) attached movably so that is can be moved along the electron beam (EB) axis in order to change the maximal backscattered electron BSE₂ detection angle (β₂).

5. The detector, according to claim 1, unique in this that it has the intermediate chamber casing (8) vacuum closed by a cathode ring (7) and a focusing cathode (4) tightly secured in the central hole of the cathode ring (7) by means of an insulating insert (5).

6. The detector, according to claim 1 and claim 5, unique in this that it has a lower throttling aperture (1) vacuum-tightly secured in the hole of the focusing cathode (4) and situated on the common axis of the electron beam (EB).

7. The detector, according to claim 1 and claim 6, unique in this that it has the lower throttling aperture (1) electrically insulated from the focusing cathode (4) and equipped with electrical leads.

8. The detector, according to claim 1, unique in this that in the neighbourhood of the anodes (3) it has at least one cathode coated with a thin emission layer (17) of a material with a secondary emission factor higher than unity, advantageously an alundum Al₂O₃:Al layer.

9. The detector, according to claim 1, unique in this that between the anodes (3) it has separating walls (18) with conducting surfaces, arranged symmetrically around the electron beam (EB) axis.

10. The detector, according to claim 1, unique in this that inside the intermediate chamber (16) it has a quadrant semiconductor BSE₁ detector (13) with four sectors active for electrons, arranged symmetrically relative to the electron beam (EB) axis, with their active surfaces facing the lower throttling aperture (1).

11. The detector, according to claim 1 and claim 10, unique in this that between the quadrant semiconductor BSE₁ (13) and the lower throttling aperture (1), on the electron beam (EB) it has an internal BSE₁ aperture (15) defining a limited BSE₁ detection angle BSE₁ (α₂').

12. The detector, according to claim 1 and claim 10, unique in this that between the quadrant semiconductor BSE₁ detector (13) and the lower throttling aperture (1) it has four vertical partitions (19) symmetrically arranged around the electron beam (EB) axis, with the projections of the vertical partitions (19), parallel to the electron beam (EB) axis, onto the quadrant semiconductor BSE₁ detector (13), situated along the gaps between this detector (13)'s sectors active for electrons.

13. The detector, according to claim 1 and claim 10, unique in this that the parallel projections of the straight lines connecting the geometric centres of the opposite anodes (3) onto the quadrant semiconductor BSE₁ detector (13) are situated approximately on the straight lines connecting the geometric centres of this detector (13)'s opposite sectors active for electrons.

14. The detector, according to claim 1, unique in this that it has the intermediate chamber (16) connected to a vacuum system (RP) equipped with an auxiliary valve dosing gas into the intermediate chamber (16) during the operation of the detector.

15. The detector, according to claim 1, unique in this that it has the intermediate chamber casing (8) attached movably relative to objective lens (11) and connected with a mechanism making its movement possible.

16. The detector, according to claim 1, unique in this that it has the intermediate chamber casing (8) connected to the objective lens (11) via mechanical elements making impossible their mutual movement during the operation of the detector.

17. The detector, according to claim 1 and claim 9, unique in this that it has the quadrant semiconductor BSE₁ (13) immovably attached to the objective lens (11) via a connector (12) and has the intermediate chamber casing (8) attached movably relative to the objective lens (11) and connected with a mechanism making its movement possible.
